Europäisches Patentamt

European Patent Office

Office européen des brevets

(11) Publication number: **0 166 607 B1**

# EUROPEAN PATENT SPECIFICATION

(45) Date of publication of patent specification: 03.04.91    (51) Int. Cl.⁵: **H03M 7/42**, H03M 7/30, G10L 9/18

(21) Application number: 85304537.5

(22) Date of filing: 26.06.85

The file contains technical information submitted after the application was filed and not included in this specification

(54) Encoding method for time encoded data.

(30) Priority: 28.06.84 GB 8416495

(43) Date of publication of application:
02.01.86 Bulletin 86/01

(45) Publication of the grant of the patent:
03.04.91 Bulletin 91/14

(84) Designated Contracting States:
**AT BE CH DE FR IT LI LU NL SE**

(56) References cited:
EP-A- 0 004 759
US-A- 3 394 352
US-A- 4 192 010

**ELECTRONICS & COMMUNICATIONS IN JA-PAN, vol. 66, no. 12, December 1983, pages 63-71, Scripta Publishing Co., Silver Spring, Maryland, US; T. SAITOH et al.: "Reversible predictive coding of continuous-tone picture signals using block adaptive variable-length codes - a scheme of reversible coding for picture data base"**

(73) Proprietor: **King, Reginald Alfred**
**Merrow Down**
**Woolstone Faringdon Oxon SN7 7QL(GB)**

(72) Inventor: **King, Reginald Alfred**
**Merrow Down**
**Woolstone Faringdon Oxon SN7 7QL(GB)**

(74) Representative: **Lawrence, Brian Richard**
**59 Shenfield Place**
**Shenfield Brentwood Essex CM15 9AH(GB)**

## Description

The present invention relates to a method of encoding time encoded data, and in particular, but not exclusively, to the encoding of time encoded speech.

Electrical waveforms derived from human speech are complex in character, having significant components extending from below 300 Hz, to above 3kHz and a wide dynamic range. Such waveforms may be converted into streams of digital data by known methods such as Pulse Code Modulation (PCM),Delta Modulation or Time Encoding. In PCM, the analogue speech waveform is sampled and a digital code is assigned to each sample to indicate the instantaneous amplitude of the analogue waveform at the time the sample was taken. However, to obtain acceptable quality the sampling rate must be at least double the bandwidth of the waveform. Furthermore, the digital code indicating amplitude normally comprises at least an 8 bit code. Hence, assuming a bandwidth of 3kHz for the speech waveform, it can be seen that the digital data stream will contain 48 k bits/second. In most commercial applications 64 k bits/second are generated as the bandwidth is taken as 4 kHz.

In Delta Modulation the analogue speech waveform is sampled, as with PCM. A single bit descriptor code is then assigned to each sample in order to describe the amplitude of the sample with respect to the preceding sample. However, as a single bit descriptor code is used it is necessary to use a higher sample rate than PCM and, for commercial applications, a sample rate of at least 32 k bits/second is necessary. Hence, the digital data stream generated will contain 32 k bits/second.

In Time Encoding, the locations of the real zeros in the analogue waveform are determined by quantising in the time domain. The shape of the waveform between successive zeros is then determined by studying the number of events, e.g. maxima or minima, in the waveform between successive real zeros. A series of coded symbols is generated by grouping the successive zeros with their associated events. These symbols are known as TES symbols, and the analogue speech waveform can be reconstructed from them.

Since the analogue speech waveform is of restricted bandwidth only a limited number of coded symbols are necessary. For example, in a speech waveform having a bandwidth of 300 Hz to 3.3 kHz with a sampling rate of 20k samples/second, only a limited variation in half cycle durations longer than a number of quanta (sampling periods) can occur. At the highest frequency, 3.3 kHz, the half cycle duration is approximately 3 quanta (sampling periods); at the lowest frequency, 300Hz the half cycle duration is approximately 34 quanta. By applying mapping logic it has been found that an alphabet of about 27 TES symbols can be used to define the analogue speech waveform. As there are fewer than 32 symbols, a 5 bit constant length (linear) binary word may be allocated to represent each TES symbol. Hence, the TES symbol stream is represented by a digital data stream of 5 bit constant length (linear) data words. In practice, however, additional data may be included, such as amplitude information so that each symbol would be represented by a (5 + n) bit constant length (linear) data word, where n is normally a 1 to 3 bit code word. The principles of Time Encoded Speech (TES) are described in detail in UK Patent GB-B-2020517. By adopting Time Encoding it is possible to represent an analogue speech waveform by a digital data stream having a bit rate of approximately 12k bits/second, whilst maintaining acceptable quality.

It is often desirable to store digitally encoded speech but it can be seen that, with existing methods of encoding, large memories are required to store relatively short periods of speech because of the number of bits of digital information to be stored per second of the analogue speech waveform. In order to reduce memory requirements, a reduction in the bit rate of the digital data stream is both desirable and necessary.

It is an object of the present invention to provide a method of encoding data whereby the bit rate of the digital data stream representing the data is reduced substantially from that obtained with existing methods. The method of the present invention is, therefore, particularly applicable when it is required to store speech in digital form. Furthermore, in transmission by line or radio the lower bit rate means that a narrower bandwidth may be adopted for transmission. If a narrower bandwidth is not adopted the time required to transmit a given quantity of data is reduced, which is particularly advantageous when the data is to be transmitted by telephone line link.

According to the present invention there is provided a method of encoding time encoded data in the form of a stream of time encoded symbols, the method comprising determining the repetition frequency of the time encoded symbols in at least one time frame of the time encoded symbol stream, determining the repetition frequency of the time encoded symbols in the or each time frame, deriving a precursor code indicative of the identity and repetition frequency of the time encoded symbols in the or each time frame, applying a variable or fixed length code to the time encoded symbols in the or each time frame in accordance with the precursor code to generate a code series substantially corresponding to the time encoded symbols of said time frame and, for the or each time frame, grouping the precursor code with the code series.

A preferred embodiment of the present invention comprises dividing the time encoded symbol stream into a number of succesive time frames and deriving a precursor code and a code series for each time frame, grouping the precursor code and the code series for each time frame, and, in respect of successive time frames, storing the grouped precursor code and code series for each time frame in a sequence corresponding to that of the successive time frames from which they are derived.

The code series which is generated substantially corresponds to the time encoded symbols of at least one time frame, that means that the precursor code is indicative of the identity and relative repetition frequency of the time encoded signals.

Preferably the precursor code is indicative of the time encoded symbols in descending order of repetition frequency.

The variable length non-linear code may be a variable length entropic code.

The grouped precursor codes and non-linear code series for successive time frames may be transmitted before or after storage.

Preferably, the variable length entropic code is of the form 1, 10, 100, 1000 ....

The variable length entropic code may be a two-state two digit suboptimum code.

Preferably, the succesive time frames are of unequal period.

Any time frame period may be determined by interpreting the distribution of the time encoded symbols in the time encoded symbol stream.

Preferably, any time frame period is determined by interpreting when the number of different time encoded symbols in the time encoded symbol stream exceeds a predetermined number of different time encoded symbols.

Advantageously, any time frame period is determined when any time encoded symbol in excess of the predetermined number of different time encoded symbols is interpreted more than a predetermined number of times.

The successive time frames may be of 10 to 30 milliseconds period.

For any time frame, the non-linear code series may be generated by applying sequentially a number of different variable length non-linear codes to the time encoded symbols to derive a corresponding number of non-linear code series, each representing the time frame, and determining and selecting the non-linear code series of shortest length, and modifying the precursor code to indicate also the identity of the variable length non-linear code from which the selected non-linear code series is generated.

The encoding method may also comprise, for any time frame, comparing the grouped precursor code and non-linear code series with the linear series of constant length words representing the time encoded symbols in the time frame and selecting the grouped precursor code and non-linear code series or the linear series of constant length words representing the time encoded symbols in dependence upon the results of the comparison.

Preferably, the method of the present invention includes decoding of the grouped precursor codes and non-linear code series comprising, in respect of succesive time frames, storing the precursor code and non-linear code series, interpreting the precursor code, assigning the time encoded symbols to the non-linear code series in accordance with the precursor code and combining the assigned time encoded symbols in the sequence of the successive time frames to reconstruct the time encoded symbol stream.

The present invention will now be described, by way of example, with reference to the accompanying drawings in which:-

Figure 1 illustrates a table showing Time Encoded Speech symbol distribution for the word "shopping";

Figure 2 illustrates a flow chart showing an encoding method according to the present invention; and

Figure 3 illustrates a flow chart showing a method according to the present invention for decoding data encoded with the method shown in Figure 2.

A stream of Time Encoded Speech (TES) symbols generated in accordance with the method disclosed in UK Patent GB-B-2020517 comprises an alphabet of 27 symbols.

It has been determined that, although 27 TES symbols may be required to define the entire analogue speech waveform, only a limited number of the 27 symbols occur in a time frame of the TES symbol stream. For example, it has been found that fewer than 10 TES symbols normally occur in a 10 millisecond time frame. In the method of the present invention the TES symbols occurring in each time frame may be encoded by means of a bounded variable length non-linear code so as to reduce the number of bits required to represent each second of the analogue speech waveform. A bounded variable length non-linear code is any code consisting solely of code words with start (or stop) element combinations which are common to all words in the code set. These unique start (or stop) element combinations can be used to identify readily the start (or stop) boundaries of the variable length code words in the code. One example of a non-linear code is 1, 10, 100, 1000..... where the element 1 is used to indicate the boundary of each code word. Other types of non-linear codes, such as two state, two digit suboptimum bounded codes, are referred to in Electronics Letters Vol. 17 no. 12, 11th June 1981 pages 394-396.

Although variable length non-linear codes are suitable for encoding the restricted number of different TES symbols in a 10 millisecond time frame, they are not suitable for application to the entire TES symbol stream as it would be necessary to apply a non-linear code to the entire TES alphabet of 27 symbols. In applying a non-linear code, the 5 bit binary word representing the TES symbol occuring most frequently in a time frame is replaced by the shortest non-linear code word and vice versa. For example, in conventional Time Encoded Speech, if the TES symbol 2 occurs 8 times in a time frame, this would generate 40 bits of information in the digital data stream as the symbol 2 is represented by a 5 bit binary word. If a non-linear code of the form 1, 10, 100, 1000.... is applied to the TES symbols, the symbol 2 is represented by the non-linear code word 1 and hence, the eight occurrences of the TES symbol 2 generate only 8 bits in the digital data stream; a bit rate reduction of 5 to 1. For the second most frequent TES symbol, the 5 bit binary word is represented by the non-linear code word 10, reducing further the number of bits generated; and so on.

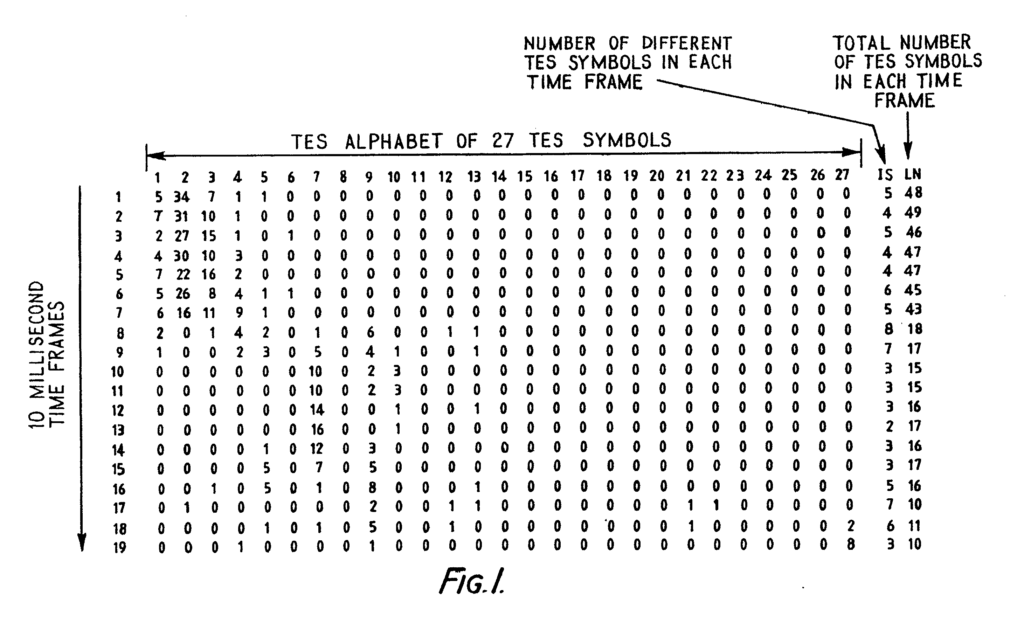

The reduction in the bit rate of the digital data stream which is achieved by applying a variable length non-linear code of the form 1, 10, 100, 1000... can be seen more clearly with reference to Figure 1 of the accompanying drawings. Figure 1 illustrates a table of TES symbol distribution for the word "shopping". It can be seen that there is a total of 48 symbols in the first 10 millisecond time frame. However, only 5 different TES symbols are present; namely symbols 1 to 5. Symbol 2 is the most frequent, with a repetition frequency of 34 whilst symbols 4 and 5 are the least frequent, with a repetition frequency of 1.

As there are 48 symbols in time frame 1, and each symbol is represented by a 5 bit binary word, these would be represented in normal Time Encoded Speech by 240 bits (5 x 48) in the digital data stream. If a variable length non-linear code of the form 1, 10, 100, 1000...... is applied to TES symbols 1 to 5 in the manner described previously, the total of 48 symbols in time frame 1 can be represented by only 97 bits in the digital data stream. For the entire nineteen 10 millisecond time frames shown in Figure 1 the number of bits required to represent the TES symbols in these time frames can be reduced from 2515 bits to 1323 bits without any loss of information.

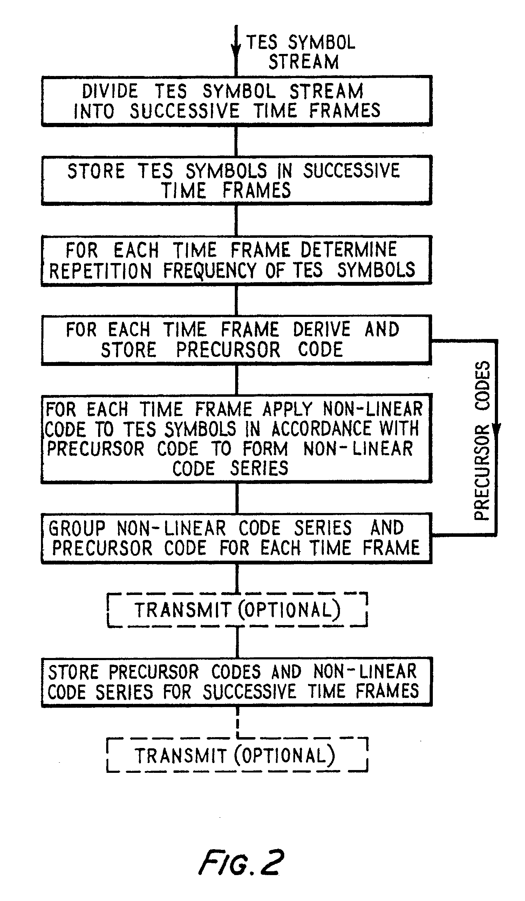

Referring now to Figure 2, time encoded data derived from, for example, speech, can be encoded by dividing the TES symbol stream representing the speech, in the form of a linear series of constant length words, into a number of successive time frames such as, for example, 10 millisecond time frames, This can be achieved by known means, such as gating the TES symbol stream at 10 millisecond time intervals. The TES symbols occurring in successive time frames, each represented by a 5 bit binary word, are then stored. Any store suitable for storing quantities of digital information may be used for this purpose. For each time frame the repetition frequency of each different TES symbol is then determined. This can be achieved by recognising the binary word assigned for any TES symbol and then incrementing a counter each time the binary word is recognised.

A precursor code is now derived in respect of each time frame. To enable decoding of TES symbols encoded by means of a non-linear code it is necessary to determine, for each time frame, the non-linear code word applied to each TES symbol. This is achieved by means of the precursor codes.

For each time frame the precursor code is derived by storing the identity of each TES symbol in accordance with its repetition frequency. The identity of each TES symbol is known as it has been used in order to determine its repetition frequency. Hence, if the TES symbol identities are assembled in a pre-set sequence, for example, in descending order of repetition frequency, a precursor code is derived which indicates the identity of each TES symbol and its repetition frequency in relation to the repetition frequency of other TES symbols occurring in the time frame. The precursor code is then stored.

A non-linear code is then applied to the TES symbols stored in respect of each time code to produce a non-linear code series for each time code. The non-linear code words are applied to the TES symbols in accordance with the precursor code such that the shortest non-linear code word is applied to the TES symbol with the highest repetition frequency.

For example, in Figure 1, the TES symbols occurring in time frame 1 in descending order of repetition frequency are 2, 3, 1, 4, 5. The identities of these TES symbols can be identified by the precursor code symbols A, B, C, D, E. Precursor code symbol A identifies the TES symbol with the highest repetition frequency as symbol 2 whilst precursor code symbol E identifies the TES symbol with the lowest repetition frequency as symbol 5. If the non-linear code 1, 10, 100, 1000,..... is applied to the TES symbols in accordance with the precursor code, the non-linear code words 1, 10, 100, 1000, l0000, are applied respectively to TES symbols 2, 3, 1, 4, 5 each time they are identified so as to produce the non-linear code series for the time frame.

The precursor code for each time frame is then grouped with its associated non-linear code series and stored. The grouping of the precursor codes and the non-linear code series enables the identities of the TES symbols represented by the non-linear code series to be identified when it is required to reconstruct the analogue speech waveform.

The grouped precursor codes and non-linear code series for all the time frames may then be stored in the same sequence as the successive time frames of the TES symbol stream which they represent. In this way, successive 10 millisecond slots of the analogue speech waveform are represented in the storage means by successive grouped precursor codes and non-linear code series. Although a 10 millisecond time period has been described, time periods of shorter or longer duration may be adopted or the successive time frames may be of unequal period. For example, the time frame boundaries, which define the time frame periods, may be determined by interpreting the distribution of the TES symbols in the TES symbol stream. One method by which these frame boundaries may be determined is to accumulate TES symbols from the incoming TES symbol stream until such time as the number of different TES symbols accumulated exceeds a predetermined number of different symbols. This can be illustrated with reference to Figure 1. If, for example, the predetermined number of different TES symbols is chosen as 6 symbols, the TES symbols in the original TES symbol stream associated with time frames 1 to 7 of Figure 1 would be accumulated into a single time frame of at least 70 milliseconds time period as 6 or fewer different TES symbols are associated with time frames 1 to 7. The exact boundary of the time frame so generated would be determined when the seventh different TES symbol is interpreted in the TES symbol stream. Hence, for the TES symbol distribution for the word "shopping" shown in Figure 1, and assuming that TES symbol 7 shown in time frame 8 is the first symbol to be interpreted after the TES symbols 1 to 6 shown in time frames 1 to 7, a time frame of approximately 70 milliseconds would be generated in which the TES symbols 1 to 6 have repetition frequencies of, respectively, 36, 186, 77, 21, 3, 2. The second time frame would commence when the TES symbol 7 shown in time frame 8 is interpreted. The division of the TES symbol stream into time frames in this manner gives rise to a further reduction in the bit rate of the data stream representing the analogue speech waveform as, in the example previously described with reference to Figure 1 having equal period 10 millisecond time frames, a precursor code is generated for every 10 milliseconds of the speech waveform whereas, by determining the time frame boundaries by interpreting the TES symbols, as described above, one precursor code is generated for at least the first 70 milliseconds of the analogue speech waveform.

This method of encoding the TES symbols results in a considerable reduction in the number of bits of digital information respresenting each second of the analogue speech waveform without any loss of information.

The time frame boundaries, and hence the time frame periods, may also be determined by interpreting not only when the numbers of different TES symbols in the time encoded symbol stream exceeds a predetermined number of different symbols but also when any TES symbol in excess of the predetermined number of different TES symbols is interpreted more than a predetermined number of times. For example, assume that the predetermined number of different TES symbols is chosen as 6 symbols and that, in the first 70 milliseconds of the TES symbol stream only TES symbols 1 to 6 are interpreted. If, then, TES symbol 7 is interpreted once only shortly after 70 milliseconds followed by TES symbols 1 to 6 until 100 milliseconds the single interpretation of TES symbol 7 could be disregarded and the boundary of the time frame could be determined at 100 milliseconds as this would not affect significantly any speech waveform reproduced from the encoded data.

If, however, TES symbol 7 is interpreted say 16 times between 70 and 80 milliseconds these may not be disregarded as this could change the character of any speech reconstructed from the encoded data and hence, the boundary of the time frame would be determined at the first interpretation of TES symbol 7. This procedure may give rise to further reductions in the bit rate of the data stream representing the analogue speech waveform.

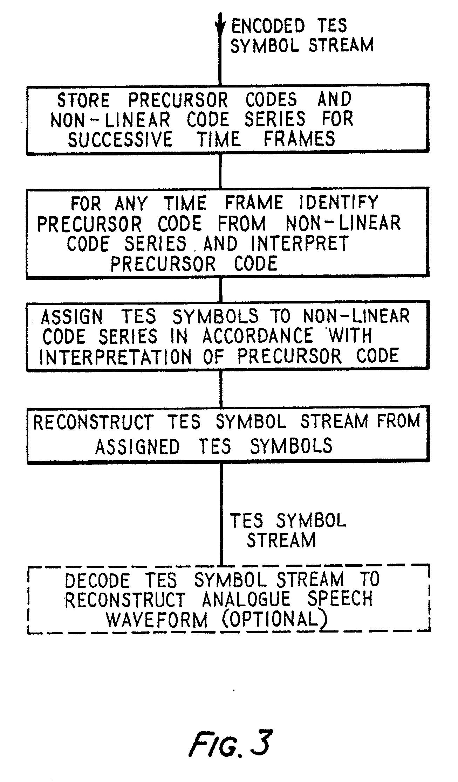

In order to reconstruct the analogue speech waveform, for example after transmission by radio or line link, the encoded TES symbols are decoded as shown in Figure 3. The grouped precursor codes and non-linear code series representing successive time frames of the TES symbol stream are stored. For each time frame the precursor code is then identified from its associated non-linear code series and interpreted. By interpreting the precursor code the identity of any TES symbol represented by any non-linear code word in the non-linear code series can be determined. Referring to the example described previously with respect to Figure 1 in connection with encoding, the precursor code would be interpreted as A, B, C, D, E, with symbol A identifying TES symbol 2 as having the highest repetition frequency.

Whenever the non-linear code word 1 is detected in the non-linear code series, this is decoded as TES symbol 2 as the non-linear code word 1 was assigned to the TES symbol with the highest repetition frequency, and the TES symbol with the highest repetition frequency is identified as symbol 2 by the precursor code. This procedure is followed for the non-linear code words 10, 100, 1000, 10,000 and assigning the respective TES symbols so as to reconstruct the TES symbol stream from which the analogue speech waveform can be reproduced.

In the example described above in connection with Figure 1 the same variable length non-linear code is applied to the TES symbols in each time frame. It has been found however that, dependent upon the TES symbol disribution in any time frame, it may be advantageous to generate the non-linear code series for any time frame by applying a variable length non-linear code which differs from the variable length non-linear code applied to the TES symbols in another time frame. The non-linear code for any time frame may be selected as follows.

The different variable length non-linear codes are applied sequentially to the TES symbols in the time frame and the non-linear code series generated by applying each non-linear code are stored. The non-linear code series may then be compared and that selected which contains the least number of bits.

However, in order to decode the encoded data it is necessary to indicate which variable length non-linear code has been selected for the time frame. This can be achieved by including information indicating the identity of the selected non-linear code in the precursor code. This information may be read in the decoder which would enable the decoder to interpret correctly the non-linear code series for the time frame.

Furthermore, it has also been found that the application of a variable length non-linear code to the stored TES symbols in a time frame may not necessarily generate a non-linear code series containing fewer bits than the linear series of constant length words representing the TES symbols in the time frame. Hence, a comparison may be carried out between the linear and non-linear series for any time frame and the series containing the least number of bits selected to represent the time frame in the encoded data. The grouped precursor codes and non-linear code series stored in respect of successive time frames may, therefore, be interleaved with linear series of constant length words in order to reduce the bit rate of the encoded data stream.

Moreover, when a restricted number of different TES symbols occur in a time frame the TES symbols in the time frame may be encoded by applying a fixed length code to each symbol to generate a code series for the time frame. For example, only 3 different TES symbols may occur in a 10 millisecond time frame. In the original TES symbol stream these symbols would be represented by three constant length data words of at least 5 bits; a total of at least 15 bits. However, 3 different TES symbols may be encoded by applying a two bit linear code to each symbol and hence, can be represented by a total of 6 bits. It can be seen, therefore, that if each word of the fixed length code contains fewer bits than the constant length data words assigned to the TES symbols in the original TES symbol stream a reduction in the bit rate of the data stream can be achieved.

Although the present invention has been described with reference to encoding time encoded speech it is to be understood that the method may be applied to encode other forms of time encoded data wherever it is required to reduce the bit rate of the data stream representing the data.

## Claims

1. A method of encoding time encoded data in the form of a stream of time encoded symbols, the method comprising determining the repetition frequency of the time encoded symbols in at least one time frame of the time encoded symbol stream, determining the repetition frequency of the time encoded symbols in the or each time frame, deriving a precursor code for the or each time frame indicative of the identity and relative repetition frequency of the time encoded symbols in the or each time frame, applying a variable or fixed length code to the time encoded symbols in the or each time frame in accordance with the precursor code to generate a code series substantially corresponding to the time encoded symbols of said time frame and, for the or each time frame, grouping the precursor code with the code series.

2. A method according to claim 1 comprising dividing the time encoded symbol stream into a number of successive time frames, deriving a precursor code and a code series for each time frame, grouping the precursor code and code series for each time frame and, in respect of successive time frames, storing the grouped precursor code and code series for each time frame in a sequence corresponding to that of the successive time frames from which they are derived.

3. A method according to claim 1 or claim 2, characterised in that the precursor code for the or each time frame is indicative of the time encoded symbols in descending order of repetition frequency.

4. A method according to any one of claims 1, 2 or 3 characterised in that the or each time frame is of unequal period.

5. A method according to claim 4 characterised in that the period of any time frame is determined by interpreting the distribution of the time encoded symbols in the time encoded symbol stream.

6. A method according to claim 4 characterised in that the period of any time frame is determined by interpreting when the number of different symbols in the time encoded symbol stream exceeds a predetermined number of different time encoded symbols.

7. A method according to claim 6 characterised in that the period of any time frame is determined when any time encoded symbol in excess of the predetermined number of different time encoded symbols is interpreted more than a predetermined number of times.

8. A method according to any one of claims 1, 2 or 3 characterised in that the or each time frame is of 10 to 30 milliseconds period.

9. A method according to any one of the preceding claims characterised in that the code applied in accordance with the precursor code comprises a variable length non linear code.

10. A method according to claim 9 characterised in that the non linear code comprises an entropic code of the form 1, 10, 100, 1000 ........

11. A method according to claim 9 characterised in that the non linear code comprises a two state two digit sub optimom code entropic code.

12. A method according to any one of the preceding claims characterised in that, for the or each time frame, the code series may be generated by applying sequentially a number of different linear and non linear codes to the time encoded symbols to derive a corresponding number of code series, each representing the or each time frame determining and selecting the code series of shortest length, and modifying the precursor code to indicate the identity of the variable or fixed length code from which the selected code series is generated.

13. A method according to any one of the preceding claims characterised by, for the or each time frame, comparing the grouped precursor code and code series with the time encoded symbols, represented as a linear series of constant length words, and selecting the grouped precursor code and code series or the linear series of constant length words representing the time encoded symbols in dependence upon the results of the comparison.

14. A method according to any one of claims 2 to 13 characterised in that the grouped precursor codes and code series for the time frames are transmitted before or after storage.

15. A method according to any one of the preceding claims characterised by, for the or each time frame, decoding the grouped precursor code and code series by interpreting the precursor code and assigning the time encoded symbols for the code series in accordance with the interpretation of the precursor code.

16. A method according to any one of the preceding claims characterised in that the data for encoding comprises time encoded speech.

**Revendications**

1. Procédé de codage de données codées temporellement sous forme d'un courant de symboles codés temporellement, le procédé comprenant la détermination de la fréquence de répétition des symboles codés temporellement dans au moins une tranche temporelle du courant de symboles codés temporellement, la détermination de la fréquence de répétition des symboles codés temporellement de la tranche ou de chaque tranche temporelle, la dérivation d'un code précurseur de la tranche ou de chaque tranche, ce code étant représentatif de l'identité et de la fréquence relative de répétition des symboles codés temporellement de la tranche ou de chaque tranche, l'application d'un code de longueur fixe ou variable aux symboles codés temporellement de la tranche ou de chaque tranche en fonction du code précurseur afin qu'une série de codes correspondant pratiquement aux symboles codés temporellement de la tranche temporelle soit créée, et, pour la tranche ou pour chaque tranche, le regroupement du code précurseur et de la série de codes.

**2.** Procédé selon la revendication 1, comprenant la division du courant de symboles codés temporellement en un certain nombre de tranches temporelles successives, la dérivation d'un code précurseur et d'une série de codes pour chaque tranche temporelle, le regroupement du code précurseur et de la série de codes pour chaque tranche temporelle et, pour les tranches temporelles successives, la mémorisation du code précurseur et de la série de codes regroupés pour chaque tranche temporelle suivant une séquence correspondant à celle des tranches temporelles successives à partir desquelles ils ont été dérivés.

**3.** Procédé selon la revendication 1 ou 2, caractérisé en ce que le code précurseur de la tranche ou de chaque tranche temporelle est représentatif des symboles codés temporellement dans l'ordre décroissant de la fréquence de répétition.

**4.** Procédé selon l'une quelconque des revendications 1, 2 et 3, caractérisé en ce que la tranche ou chaque tranche temporelle a une période inégale.

**5.** Procédé selon la revendication 4, caractérisé en ce que la période d'une tranche temporelle quelconque est déterminée par interprétation de la distribution des symboles codés temporellement dans le courant de symboles codés temporellement.

**6.** Procédé selon la revendication 4, caractérisé en ce que la période de chaque tranche temporelle est déterminée par interprétation du moment où le nombre de symboles différents du courant de symboles codés temporellement dépasse un nombre prédéterminé de symboles codés temporellement différents.

**7.** Procédé selon la revendication 6, caractérisé en ce que la période d'une tranche temporelle quelconque est déterminée lorsqu'un symbole codé temporellement quelconque, au-delà du nombre prédéterminé de symboles codés temporellement différents, est interprété un nombre de fois supérieur à un nombre prédéterminé.

**8.** Procédé selon l'une quelconque des revendications 1, 2 et 3, caractérisé en ce que la tranche ou chaque tranche temporelle est une période comprise entre 10 et 30 ms.

**9.** Procédé selon l'une quelconque des revendications précédentes, caractérisé en ce que le code appliqué en fonction du code précurseur est un code non linéaire de longueur variable.

**10.** Procédé selon la revendication 9, caractérisé en ce que le code non linéaire est un code entropique de la forme 1, 10, 100, 1000.

**11.** Procédé selon la revendication 9, caractérisé en ce que le code non linéaire est un code entropique codé de façon sous-optimale à deux chiffres à deux états.

**12.** Procédé selon l'une quelconque des revendications précédentes, caractérisé en ce que, pour la tranche ou chaque tranche temporelle, la série de codes peut être créée par applications successives d'un nombre de codes linéaires et non linéaires différents aux symboles codés temporellement afin qu'un nombre correspondant de séries de codes soit dérivé, chaque série représentant la tranche ou chaque tranche, par détermination et sélection de la série de codes de plus courte longueur, et par modification du code précurseur afin qu'il indique l'identité du code de longueur fixe ou variable à partir duquel la série de codes sélectionnés est créée.

**13.** Procédé selon l'une quelconque des revendications précédentes, caractérisé, pour la tranche ou chaque tranche temporelle, par la comparaison du code précurseur et de la série de codes qui sont regroupés aux symboles codés temporellement, représentés par une série linéaire de mots de longueur constante, et par sélection du code précurseur et de la série de codes qui sont regroupés ou de la série linéaire de mots de longueur constante représentant les symboles codés temporellement selon les résultats de la comparaison.

**14.** Procédé selon l'une quelconque des revendications 2 à 13, caractérisé en ce que les codes précurseurs et la série de codes qui sont regroupés pour les tranches temporelles sont transmis avant ou après mémorisation.

**15.** Procédé selon l'une quelconque des revendications précédentes, caractérisé, pour la tranche ou chaque tranche temporelle, par le décodage du code précurseur et de la série de codes qui sont regroupés par interprétation du code précurseur et affectation des symboles codés temporellement à la série de codes en fonction de l'interprétation du code précurseur.

**16.** Procédé selon l'une quelconque des revendications précédentes, caractérisé en ce que les données à coder représentent de la parole codée temporellement.

**Ansprüche**

1. Verfahren zur Kodierung zeitkodierter Daten in Form eines Stromes von in der Zeit kodierter Symbole, dadurch gekennzeichnet, dass die Repetitionsfrequenz der zeitkodierten Symbole in wenigstens einem Zeitrahmen des in der Zeit kodierten Symbolstromes bestimmt wird, dass die Repetitionsfrequenz der zeitkodierten Symbole im oder in allen Zeitrahmen bestimmt wird, ein Zeigercode für den oder alle Zeitrahmen abgeleitet wird bezeichnend für die Identität und relative Repetitionsfrequenz der zeitkodierten Symbole im oder jeden Zeitrahmens, ein Code variabler oder fester Länge auf die zeitkodierten Symbole im oder in jedem Zeitrahmen in Uebereinstimmung mit dem Zeigercode angewandt wird um eine Codereihe zu erzeugen welche im Wesentlichen den zeitkodierten Symbolen besagten Zeitrahmens entspricht, für den oder jeden Zeitrahmen der Zeigercode mit den Codereihen gruppiert wird.

2. Verfahren nach Anspruch 1, dadurch gekennzeichnet, dass der in der Zeit kodierte Symbolstrom in eine Anzahl aufeinanderfolgender Zeitrahmen aufgeteilt wird, ein Zeigercode und eine Codereihe für jeden Zeitrahmen abgeleitet wird, der Zeigercode und die Codereihe für jeden Zeitrahmen gruppiert werden, bezüglich sich folgender Zeitrahmen der gruppierte Zeigercode Codereihen für jeden Zeitrahmen in eine Folge, entsprechend bedeutet aufeinanderfolgender Zeitrahmen von der sie abgeleitet sind, gespeichert werden.

3. Verfahren nach Anspruch 1 oder 2, dadurch gekennzeichnet, dass der Zeigercode für den oder jeden Zeitrahmen für die zeitkodierten Symbole in absteigender Ordnung der Repetitionsfrequenz repräsentativ ist.

4. Verfahren nach einem der Ansprüche 1 bis 3, dadurch gekennzeichnet, dass der oder jeder Zeitrahmen eine unterschiedliche Periode aufweist.

5. Verfahren nach Anspruch 4, dadurch gekennzeichnet, dass die Periode jedes Zeitrahmens durch Auswertung der Verteilung der zeitkodierten Symbole im in der Zeit kodierten Symbolstrom bestimmt wird.

6. Verfahren nach Anspruch 4, dadurch gekennzeichnet, dass die Periode jedes Zeitrahmens bestimmt wird durch Auswertung wann die Anzahl verschiedener Symbole im in der Zeit kodierten Symbolstrom eine vorbestimmte Anzahl verschiedener zeitkodierter Symbole übersteigt.

7. Verfahren nach Anspruch 6, dadurch gekennzeichnet, dass die Periode jedes Zeitrahmens bestimmt wird jedesmal wenn ein zeitkodiertes Symbol im Ueberschuss an der vorbestimmten Anzahl verschiedener zeitkodierter Symbole mehr als eine vorbestimmte Anzahl mal angetroffen wird.

8. Verfahren nach einem der Ansprüche 1 bis 3, dadurch gekennzeichnet, dass der oder jeder Zeitrahmen eine Periode von 10 bis 30 Millisekunden aufweist.

9. Verfahren nach einem der vorhergehenden Ansprüche, dadurch gekennzeichnet, dass der in Uebereinstimmung mit dem Zeigercode erzeugte Code ein längenvariabler nichtlinearere Code ist.

10. Verfahren nach Anspruch 9, dadurch gekennzeichnet, dass der nichtlineare Code aus einem entropischen Code der Form 1, 10, 100, 1000.... besteht.

11. Verfahren nach Anspruch 9, dadurch gekennzeichnet, dass der nichtlineare Code aus einem zweizustands- zwei stelligen unteroptimalen Code entropischer Code besteht.

12. Verfahren nach einem der vorhergehenden Ansprüche, dadurch gekennzeichnet, dass die Codereihen für den oder jeden Zeitrahmen durch sequentielle Anwendung einer Anzahl verschiedener linearer und nichtlinearer Codes auf die zeitkodierten Symbole erzeugt werden können um eine entsprechende Anzahl von Codereihen abzuleiten, wobei jede für den oder jeden Zeitrahmen steht, die Codereihe mit der kürzesten Länge bestimmt und ausgewählt wird und der Zeigercode zur Anzeige der Identität des variablen oder längenfesten Codes, von welchem die ausgewählte Codereihe erzeugt worden ist, modifiziert wird.

13. Verfahren nach einem der vorhergehenden Ansprüche, dadurch gekennzeichnet, dass die gruppierten Zeigercodes und Codereihen mit den zeitkodierten Symbolen, durch eine lineare Reihe von längenkonstanten Worten dargestellt, verglichen werden und dass die gruppierten Zeigercodes und Codereihen oder die lineare Reihe von längenkonstanten Worten welche die zeitkodierten Symbole darstellen abhängig vom Resultat des Vergleichs ausgewählt werden, für den oder jeden Zeitrahmen.

14. Verfahren nach einem der Ansprüche 2 bis 13, dadurch gekennzeichnet, dass die gruppierten Zeigercodes und Codereihen der Zeitrahmen vor oder nach dem Speichern übertragen werden.

15. Verfahren nach einem der vorhergehenden Ansprüche, dadurch gekennzeichnet, dass für den oder jeden Zeitrahmen die gruppierten Zeigercodes und Codereihen durch Auswertung des Zeigercodes und Zuweisung der zeitkodierten Symbole für die Codereihen in Uebereinstimmung mit der Auswertung des Zeigercodes, decodiert werden.

16. Verfahren nach einem der vorhergehenden Ansprüche, dadurch gekennzeichnet, dass die zu kodierenden Daten in der Zeit kodierte Sprache umfassen.

EP 0 166 607 B1

NUMBER OF DIFFERENT TES SYMBOLS IN EACH TIME FRAME

TOTAL NUMBER OF TES SYMBOLS IN EACH TIME FRAME

TES ALPHABET OF 27 TES SYMBOLS

10 MILLISECOND TIME FRAMES

| | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | IS | LN |
|---|---|---|---|---|---|---|---|---|---|---|---|---|---|---|---|---|---|---|---|---|---|---|---|---|---|---|---|---|---|
| 1 | 5 | 34 | 7 | 1 | 1 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 5 | 48 |
| 2 | 7 | 31 | 10 | 1 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 4 | 49 |
| 3 | 2 | 27 | 15 | 1 | 0 | 1 | 0 | 0 | 0 | 0 | 0 | 0 | 0 | 0 | 0 | 0 | 0 | 0 | 0 | 0 | 0 | 0 | 0 | 0 | 0 | 0 | 0 | 5 | 46 |
| 4 | 4 | 30 | 10 | 3 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 4 | 47 |
| 5 | 7 | 22 | 16 | 2 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 4 | 47 |
| 6 | 5 | 26 | 8 | 4 | 1 | 1 | 0 | 0 | 0 | 0 | 0 | 0 | 0 | 0 | 0 | 0 | 0 | 0 | 0 | 0 | 0 | 0 | 0 | 0 | 0 | 0 | 0 | 6 | 45 |
| 7 | 6 | 16 | 11 | 9 | 1 | 0 | 0 | 0 | 0 | 0 | 0 | 0 | 0 | 0 | 0 | 0 | 0 | 0 | 0 | 0 | 0 | 0 | 0 | 0 | 0 | 0 | 0 | 5 | 43 |
| 8 | 2 | 0 | 1 | 4 | 2 | 0 | 1 | 0 | 6 | 0 | 0 | 1 | 1 | 0 | 0 | 0 | 0 | 0 | 0 | 0 | 0 | 0 | 0 | 0 | 0 | 0 | 0 | 8 | 18 |
| 9 | 1 | 0 | 0 | 2 | 3 | 0 | 5 | 0 | 4 | 1 | 0 | 0 | 1 | 0 | 0 | 0 | 0 | 0 | 0 | 0 | 0 | 0 | 0 | 0 | 0 | 0 | 0 | 7 | 17 |
| 10 | 0 | 0 | 0 | 0 | 0 | 0 | 10 | 0 | 2 | 3 | 0 | 0 | 0 | 0 | 0 | 0 | 0 | 0 | 0 | 0 | 0 | 0 | 0 | 0 | 0 | 0 | 0 | 3 | 15 |
| 11 | 0 | 0 | 0 | 0 | 0 | 0 | 10 | 0 | 2 | 3 | 0 | 0 | 0 | 0 | 0 | 0 | 0 | 0 | 0 | 0 | 0 | 0 | 0 | 0 | 0 | 0 | 0 | 3 | 15 |
| 12 | 0 | 0 | 0 | 0 | 0 | 0 | 14 | 0 | 0 | 1 | 0 | 0 | 1 | 0 | 0 | 0 | 0 | 0 | 0 | 0 | 0 | 0 | 0 | 0 | 0 | 0 | 0 | 3 | 16 |
| 13 | 0 | 0 | 0 | 0 | 0 | 0 | 16 | 0 | 0 | 1 | 0 | 0 | 0 | 0 | 0 | 0 | 0 | 0 | 0 | 0 | 0 | 0 | 0 | 0 | 0 | 0 | 0 | 2 | 17 |
| 14 | 0 | 0 | 0 | 0 | 1 | 0 | 12 | 0 | 3 | 0 | 0 | 0 | 0 | 0 | 0 | 0 | 0 | 0 | 0 | 0 | 0 | 0 | 0 | 0 | 0 | 0 | 0 | 3 | 16 |
| 15 | 0 | 0 | 0 | 0 | 5 | 0 | 7 | 0 | 5 | 0 | 0 | 0 | 0 | 0 | 0 | 0 | 0 | 0 | 0 | 0 | 0 | 0 | 0 | 0 | 0 | 0 | 0 | 3 | 17 |
| 16 | 0 | 0 | 1 | 0 | 5 | 0 | 1 | 0 | 8 | 0 | 0 | 0 | 1 | 0 | 0 | 0 | 0 | 0 | 0 | 0 | 0 | 0 | 0 | 0 | 0 | 0 | 0 | 5 | 16 |
| 17 | 0 | 1 | 0 | 0 | 0 | 0 | 0 | 0 | 2 | 0 | 0 | 1 | 1 | 0 | 0 | 0 | 0 | 0 | 0 | 0 | 1 | 1 | 0 | 0 | 0 | 0 | 0 | 7 | 10 |
| 18 | 0 | 0 | 0 | 0 | 1 | 0 | 1 | 0 | 5 | 0 | 0 | 1 | 0 | 0 | 0 | 0 | 0 | 0 | 0 | 0 | 1 | 0 | 0 | 0 | 0 | 0 | 2 | 6 | 11 |
| 19 | 0 | 0 | 0 | 1 | 0 | 0 | 0 | 0 | 1 | 0 | 0 | 0 | 0 | 0 | 0 | 0 | 0 | 0 | 0 | 0 | 0 | 0 | 0 | 0 | 0 | 0 | 8 | 3 | 10 |

*Fig.I.*

TES SYMBOL
STREAM

DIVIDE TES SYMBOL STREAM
INTO SUCCESSIVE TIME FRAMES

STORE TES SYMBOLS IN SUCCESSIVE
TIME FRAMES

FOR EACH TIME FRAME DETERMINE
REPETITION FREQUENCY OF TES SYMBOLS

FOR EACH TIME FRAME DERIVE AND
STORE PRECURSOR CODE

FOR EACH TIME FRAME APPLY NON-LINEAR
CODE TO TES SYMBOLS IN ACCORDANCE WITH
PRECURSOR CODE TO FORM NON-LINEAR
CODE SERIES

GROUP NON-LINEAR CODE SERIES AND
PRECURSOR CODE FOR EACH TIME FRAME

PRECURSOR CODES

TRANSMIT (OPTIONAL)

STORE PRECURSOR CODES AND NON-LINEAR
CODE SERIES FOR SUCCESSIVE TIME FRAMES

TRANSMIT (OPTIONAL)

FIG. 2

ENCODED TES
SYMBOL STREAM

STORE PRECURSOR CODES AND
NON-LINEAR CODE SERIES FOR
SUCCESSIVE TIME FRAMES

FOR ANY TIME FRAME IDENTIFY
PRECURSOR CODE FROM NON-LINEAR
CODE SERIES AND INTERPRET
PRECURSOR CODE

ASSIGN TES SYMBOLS TO NON-LINEAR
CODE SERIES IN ACCORDANCE WITH
INTERPRETATION OF PRECURSOR CODE

RECONSTRUCT TES SYMBOL STREAM FROM
ASSIGNED TES SYMBOLS

TES SYMBOL
STREAM

DECODE TES SYMBOL STREAM TO
RECONSTRUCT ANALOGUE SPEECH
WAVEFORM (OPTIONAL)

*FIG. 3*